# EUROPEAN PATENT SPECIFICATION

(11) **EP 1 608 088 B1**
(45) Date of publication and mention of the grant of the patent: **08.08.2007**
(21) Application number: 05012801.6
(22) Date of filing: 14.06.2005
(51) Int. Cl.: H04B 10/155, H01S 3/042, H01S 5/024, H01S 5/068

(54) **Optical transmitter and method for transmitting optical signal**
Optischer Sender und Verfahren zur Übertragung eines optischen Signals.
Méthode et appareil pour transmettre un signal optique

(30) Priority: 16.06.2004 JP 2004177895
(43) Date of publication of application: 21.12.2005
(73) Proprietor: OpNext Japan, Inc., Yokohama-shi, Kanagawa 224-8567 (JP)
(72) Inventor: Uchida, Yoshikuni, 6-1, Marunouchi 1-chome Chiyoda-ku Tokyo (JP); Fukui, Takayoshi, 6-1, Marunouchi 1-chome Chiyoda-ku Tokyo (JP); Murakami, Keiichi, 6-1, Marunouchi 1-chome Chiyoda-ku Tokyo (JP); Nagoya, Kazutaka, 6-1, Marunouchi 1-chome Chiyoda-ku Tokyo (JP); Kankipati, Raju, 6-1, Marunouchi 1-chome Chiyoda-ku Tokyo (JP)
(74) Representative: Strehl Schübel-Hopf & Partner

(56) References cited:
- EP-A- 0 703 679
- EP-A- 0 911 928
- US-A- 4 583 228
- US-A1- 2002 126 367

## Description

### BACKGROUND OF THE INVENTION

### Field of the Invention

The present invention relates to an optical transmitter and a method for transmitting an optical signal, which maintain a constant temperature of a semiconductor laser diode by using a Peltier effect.

### Description of Related Art

The semiconductor laser diode is mounted on the Peltier element within a package of the optical transmitter. A resistance of a thermistor which is similarly mounted on the Peltier element is fed back to the Peltier element, thereby making it possible to maintain the constant temperature of the semiconductor laser diode even if an ambient temperature is changed. In this method, there are a semiconductor laser device disclosed in Fig. 3 of Japanese Laid-Open Patent Publication No. Sho 57-186383, and an optical transmitter disclosed in Fig. 1 of Japanese Laid-Open Patent Publication No. Hei 11-163462.

For the purpose of lessening a temperature setting error, there is a method using plural temperature control loops. For example, in a temperature control circuit disclosed in Fig. 2 of Japanese Laid-Open Patent Publication No. Hei 10-335725, the temperature setting error is reduced by using a method of adding the feedback values of an ambient temperature sensor and a temperature sensor that detects heat caused by a semiconductor laser diode drive current to temperature control values generated by the thermistor.

Even if the system that reduces the temperature control error is taken, a period of time taken until the temperature reaches a desired temperature cannot be greatly reduced. In general, the same is applied to a temperature control circuit of a semiconductor laser diode in which a response of the temperature control system is slow, the temperature is detected by the thermistor, and the temperature is controlled by the Peltier element. In order to reduce the period of time required until the temperature reaches the desired temperature, an open loop gain of the temperature control feedback loop must be increased. However, if the open loop gain becomes too large, a phase margin is lost, and the circuit becomes unstable.

In the case of using a tunable laser diode that changes the oscillation wavelength by changing a temperature of an active layer, it is necessary to set the temperature of the semiconductor laser diode active layer to 10 to 40 °C. When the ambient temperature range is set to -5 to 70 °C as the specification, it is necessary that the semiconductor laser diode is cooled to 60 degrees and heated to 45 degrees at the maximum by the Peltier element. In a tunable optical transmitter and a tunable optical transceiver which are mounted on a dense wavelength multiplexing transmitting device, a demand has been made to shorten as much time as possible required until an optical output and the wavelength are stabilized after a power supply turns on. Accordingly, the optical transmitter and the method for transmitting an optical signal, which are short in arrival time up to a desired setting temperature are demanded.

The period of time required until the optical output and the wavelength are stabilized depends on the heating/cooling performance of the Peltier element. The heating/cooling performance is in proportion to the size, the drive current and the drive voltage of the Peltier element. Taking the downsizing and the lower power consumption of the optical transmitter into consideration, it is difficult to greatly change those parameters.

US 2002/0,126,367 A1 discloses an optical transmitter having the features of the pre-characterising part of each of claims 1 and 2.

### SUMMARY OF THE INVENTION

The present invention has been made under the above circumstances, and therefore an object of the present invention is to provide an optical transmitter and a method for transmitting an optical signal, which realize an optimum desired temperature arrival time without changing a Peltier element size, a drive current and a drive voltage, and can conduct stable control having a sufficient phase margin.

This object is solved by the optical transmitter of claim 1 or 2 and by the method of claim 3 or 4.

To achieve the above object, according to the present invention, there is provided an optical transmitter including a temperature control circuit that increases or decreases a temperature of a laser diode mounted on a Peltier element on the basis of the characteristic such as the temperature or the wavelength of the laser diode, in which the characteristic of a filter in the temperature control circuit is switched over according to a direction of a current that flows in the Peltier element to increase a response speed of the temperature control circuit.

### BRIEF DESCRIPTION OF THE DRAWINGS

Preferred embodiments of the present invention will now be described in conjunction with the accompanying drawings, in which:
Fig. 1 is a block diagram for explaining the basic structures of a semiconductor laser diode of an optical transmitter and a temperature control circuit of the semiconductor laser diode;
Fig. 2 is a block diagram showing the laser diode of the optical transmitter and the temperature control circuit of the laser diode according to a first embodiment;
Fig. 3 is a block diagram showing the laser diode of the optical transmitter and the temperature control circuit of the laser diode according to a second embodiment;
Fig. 4 is a block diagram showing the laser diode of the optical transmitter and the temperature control circuit of the laser diode according to a third embodiment;
Figs. 5A and 5B are graphs showing open-loop transfer characteristics of a temperature control loop from a Peltier element current controller to a thermistor voltage detector according to the first embodiment, respectively;
Figs. 6A and 6B are graphs showing open-loop transfer characteristics of a temperature control loop starting from a Peltier element current controller and ending at a thermistor voltage detector according to the second embodiment, respectively;
Figs. 7A to 7D are graphs showing the simulation results in the case of using a loop filter at the time of cooling according to the first embodiment, respectively;
Figs. 8A to 8D are graphs showing the simulation results in the case of using a loop filter at the time of heating according to the first embodiment, respectively;
Fig. 9 is a block diagram showing an optical transmitter according to a fourth embodiment; and
Fig. 10 is a block diagram showing an optical transmitter/receiver according to a fifth embodiment.

### DETAILED DESCRIPTION OF THE PREFERRED EMBODIMENTS

Hereinafter, a description will be given of embodiments of the present invention with reference to the accompanying drawings.

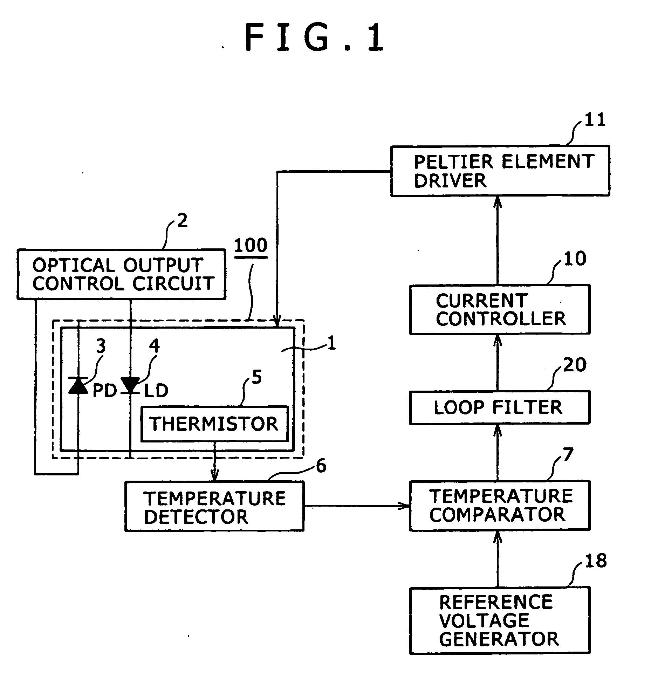

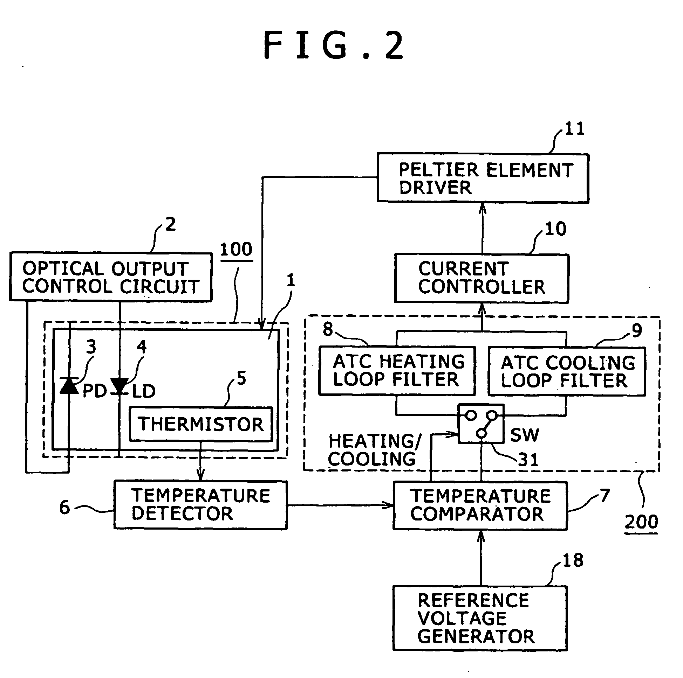

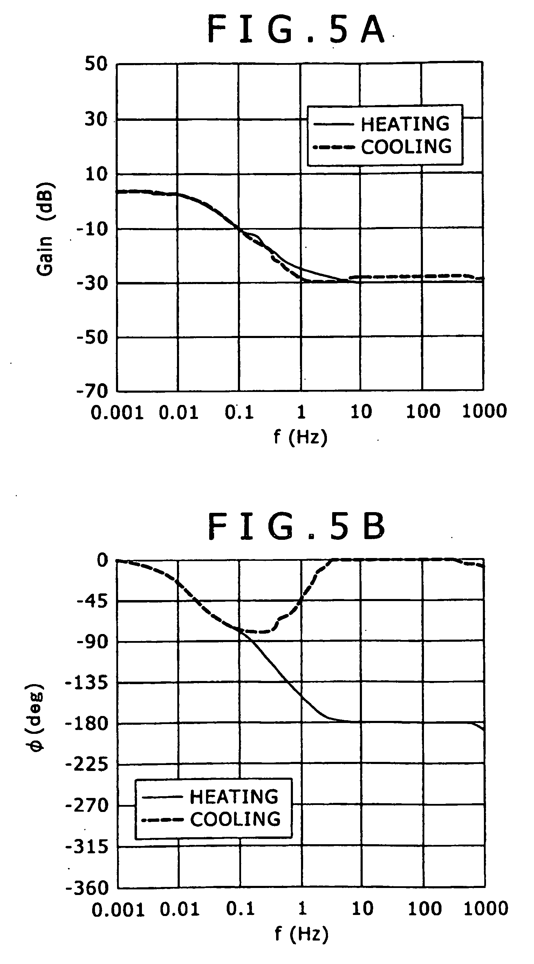

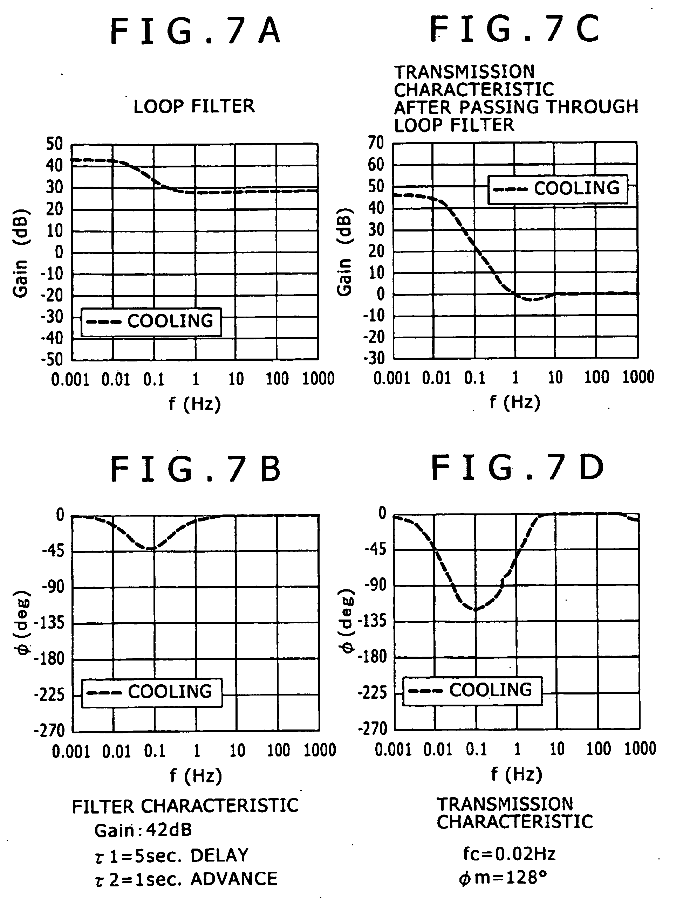

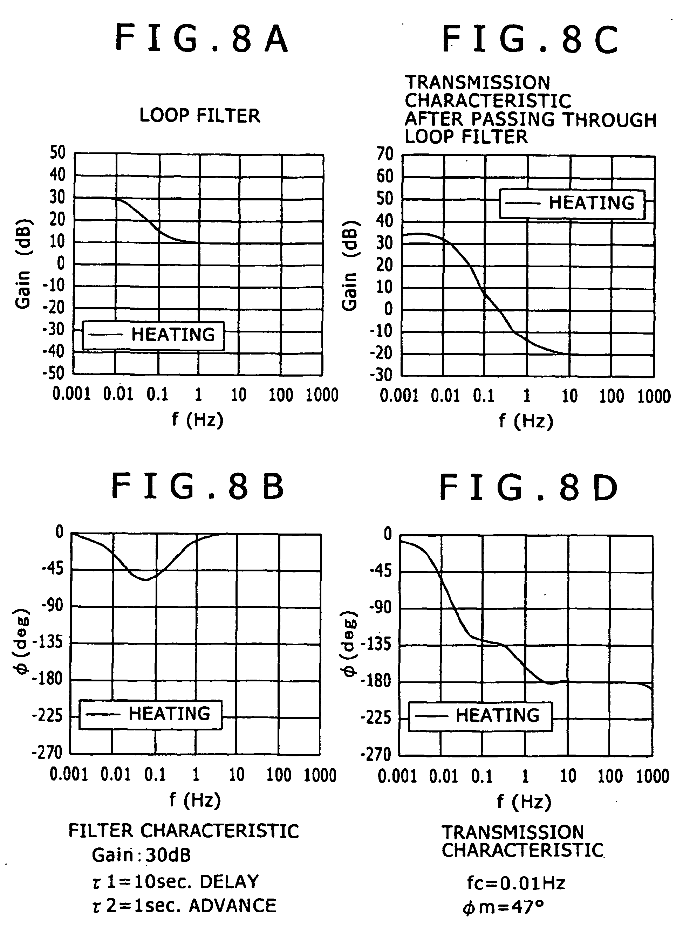

First, an optical transmitter according to an embodiment of the present invention will be described with reference to Figs. 1, 2, 5, 7 and 8. In this example, Fig. 1 shows a block diagram for explaining the basic structures of a semiconductor laser diode of an optical transmitter and a temperature control circuit of the semiconductor laser diode. Fig. 2 is a block diagram showing the laser diode of the optical transmitter and the temperature control circuit of the laser diode according to a first embodiment of the present invention. Figs. 5A and 5B are graphs showing open-loop transfer characteristics of a temperature control loop from a Peltier element current controller to a thermistor voltage detector according to the first embodiment, respectively. Figs. 7A to 7D are graphs showing the simulation results in the case of using a loop filter at the time of cooling, respectively. Figs. 8A to 8D are graphs showing the simulation results in the case of using a loop filter at the time of heating, respectively.

In the block diagram shown in Fig. 1, there are provided a temperature detector 6 that detects a semiconductor laser diode temperature by a thermistor 5, and a reference voltage generator 18 that outputs a reference temperature voltage as a temperature control desired value. The temperature detection control output and the reference voltage generator output are compared with each other by a temperature comparator 7. The temperature comparator 7 obtains a difference between the temperature detection circuit output and the reference voltage generator output and sends out a control signal. The control signal allows a gain and a phase to be adjusted by a loop filter 20, and then to be delivered to a current controller 10. The current controller 10 determines a drive current value of a Peltier element 1 by a Peltier element driver 11 so that a comparison value by the comparator 7 becomes zero.

A semiconductor laser diode (hereinafter referred to as "LD" (laser diode)) 4 and an optical output monitor photo diode (hereinafter referred to as "PD" (photo diode)) 3 that receives a rear end light of the LD 4 are mounted on the Peltier element 1. An output of the PD 3 is sent to an optical output control circuit 2 so as to be controlled such that an output of the LD 4 is held constant.

In the optical transmitter including the block shown in Fig. 1, in the case where the Peltier element 1 is used for cooling or heating, the characteristic of the loop filter 20 can be fixed to cooling or heating. However, in use of the tunable optical transmitter, there are a case in which cooling is controlled, and a case in which heating is controlled. In this event, the characteristic of the loop filter needs to be adjusted to control at a side where a time constant is smaller. This is because when the characteristic of the loop filter is adjusted to control at a side where the time constant is grater, the instability of an oscillator circuit or the like is increased at the control side that is smaller in the time constant.

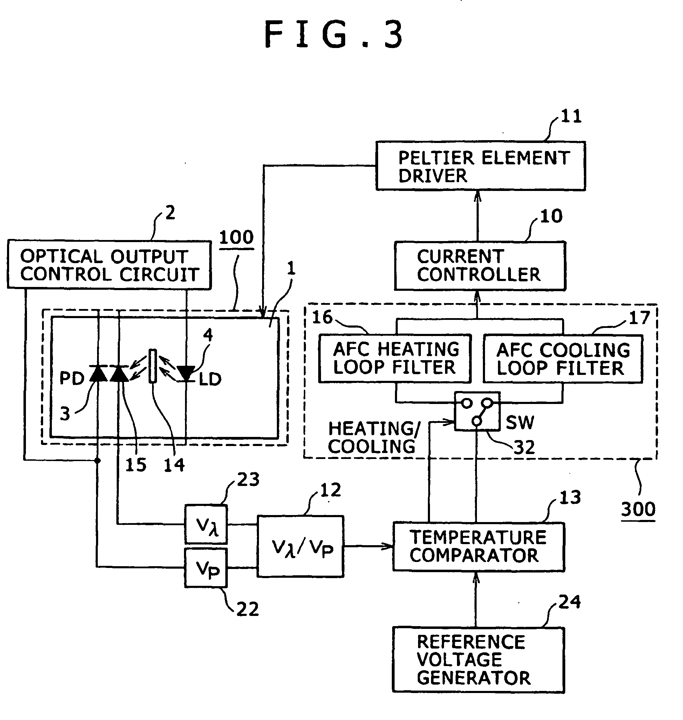

In the block diagram shown in Fig. 2, the description of the portions described with reference to Fig. 1 will be omitted. In Fig. 2, a voltage across the thermistor 5 that is mounted on the Peltier element 1 together with the LD 4 is detected by the detector 6, and the temperature that has been detected by the temperature comparator 7 is compared with the desired value. The comparison result is delivered to the current controller 10 as a control signal, and a current is allowed to flow in the Peltier element 1 by means of the Peltier element driver 11 on the basis of an output of the current controller 10. In the temperature comparator 7, an output of the temperature detector 6 is compared with an output of the reference voltage generator 18. As a result of the temperature comparison, an ATC (automatic temperature control) heating filter 8 is used in the case of heating whereas an ATC cooling loop filter 9 is used in the case of cooling. In this example, the heating means that the polarity of the current which is allowed to flow in the Peltier element is in a direction of heating the LD 4. The cooling means that the polarity of the current which is allowed to flow in the Peltier element is in a direction of cooling the LD 4. The same is applied to Figs. 3, 4, 9 and 10. The switching of the loop filter is conducted by a SW 31 of an ATC loop filter switching unit 200 under the control from the temperature comparator 7.

Now, a description will be given of reasons why the loop filter is switched over between heating and cooling with reference to Fig. 5. The control method according to this embodiment is based on the open-loop transfer characteristic of the temperature control circuit using a Peltier element described below.

Figs. 5A and 5B show the open-loop transfer characteristics of a route passing through the current controller 10, the Peltier element driver 11, the Peltier element 1, the thermistor 5 and the temperature detector 6 in the control circuit of the optical transmitter according to the first embodiment. In this example, Fig. 5A shows a frequency characteristic of a gain, Fig. 5B shows a frequency characteristic of a phase, with the heating time and the cooling time as parameters, respectively. Comparing the heating time with the cooling time, it is found that both of the heating time and the cooling time are different in the phase characteristic of the open loop from each other. The cooling side has such a characteristic that the phase is advanced up to 0 degree in the vicinity of 4 Hz. The transfer characteristic depends on what portion of the control circuit to be switched over. The phase characteristic is kept substantially constant at the heating side whereas the phase is changed only at the cooling side. This phenomenon can be explained by the characteristics in which plural transmission paths exist in a control transmission system including the Peltier element. That is, there exist a transmission path that depends on a current direction and a transmission path that does not depend on the current direction. The transmission path of the control system is different according to the direction of a current that flows in the Peltier element, that is, heating and cooling. In addition, in a thermal response, the characteristic of a time constant of about 10 seconds which is determined by an overall laser diode module determines a response speed of the entire loop. This is irrelevant to the thermal response of the Peltier element, and in the transmission characteristic shown in Fig. 5, the similar transmission characteristic is exhibited in both of heating and cooling. On the contrary, the time constant 40 msec is the characteristic related to the thermal response of the Peltier element per se, and the transmission characteristics of heating and cooling are greatly different from each other in the vicinity of 4 Hz corresponding to the above time constant.

It can be judged from the above characteristics that plural transmission paths are taken at the cooling time. A difference in the transmission path is exhibited as a difference in the phase characteristic as shown in Figs. 5A and 5B. The above exhibits the characteristics having the Peltier element per se, and there is no case in which the polarity is switched over according to the use method or the environmental condition, that is, the phase changes at the heating side. Also, the phase at the cooling side is not changed as needed, and there is no individual difference.

The simulation results in the case of using loop filters different between heating and cooling are shown in Figs. 7A to 7D and 8A to 8D. In any case, the simulation values of the respective loop filters for heating and cooling are added to the transmission characteristics shown in Figs. 5A and 5B. Figs. 7A to 7D show the transmission characteristics at the cooling side, and the transmission characteristics shown in Figs. 7C and 7D can be obtained by using the loop filters of the characteristics shown in Figs. 7A and 7B. As a result of using a lag lead filter with a gain of 42 dB, τ1 = 5 secs, and τ2 = 1 sec as the loop filter, the cutoff frequency fc becomes 0.02 Hz and the phase margin φm becomes 128 degrees.

Figs. 8A to 8D show the transmission characteristic at the heating side, and the transmission characteristics shown in Figs. 8C and 8D can be obtained by using the loop filters having the characteristics shown in Figs. 8A and 8B. As a result of using the lag lead filter with a gain of 30 dB, τ1 = 10 secs, and τ2 = 1 sec as the loop filter, the cutoff frequency fc becomes 0.01 Hz and the phase margin φm becomes 47 degrees.

In this embodiment, the loop filters for heating and cooling are appropriately used, thereby making it possible to obtain the gain at the cooling time higher than the gain at the heating time by 10 dB, and to speed up the convergence of the loop.

According to this embodiment, the loop filters for heating and cooling are provided, and the respective optimum loop filters are selected and used on the basis of the heating and cooling information, thereby making it possible to realize an optical transmitter that realizes an optimum desired temperature arrival time without remarkably changing the size of the Peltier element, the drive current and the drive voltage, and stabilizes an optical output under the control having a sufficient phase margin.

The changeover of the loop filter is not only used by switching over two filters, but also may be realized by switching over the parameters (constants) of one digital filter. In this case, the parameters are rewritten by software that has been programmed in a controller not shown. Also, the thermistor is used as the temperature sensor in this embodiment, but the temperature sensor is not limited to the thermistor, which may be replaced by a thick film temperature sensor or a thin film temperature sensor. Also, the temperature sensor does not need to sense the temperature per se of an LD, and the temperature sensor has only to measure the temperature in the vicinity of the LD. In addition, the LD may be formed of a modulator integrated LD that is integrated with a modulator.

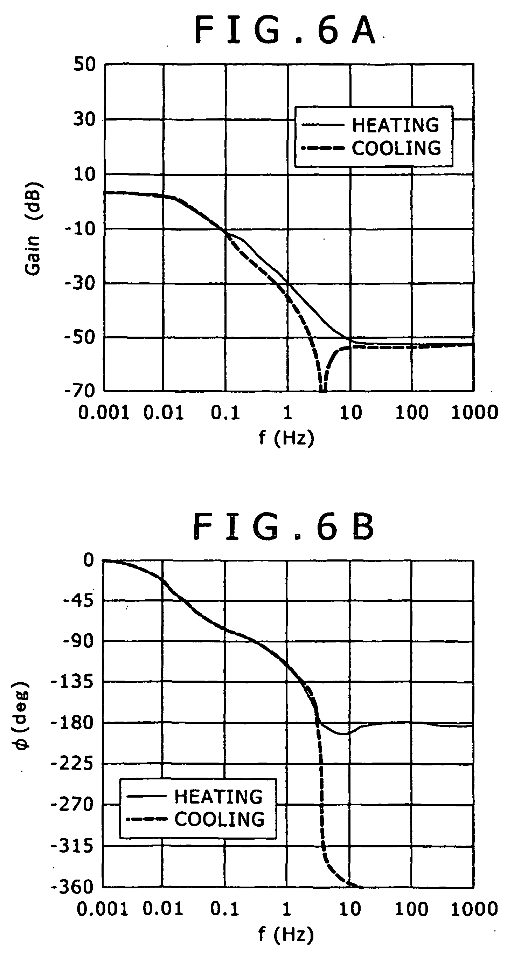

An optical transmitter according to another embodiment of the present invention will be described with reference to Figs. 3 and 6A, 6B. In this example, Fig. 3 is a block diagram showing the laser diode of the optical transmitter and the temperature control circuit of the laser diode according to a second embodiment of the present invention. Figs. 6A and 6B are graphs showing open-loop transfer characteristics of a temperature control loop from a Peltier element current controller to a thermistor voltage detector.

In the block diagram shown in Fig. 3, a detailed description of the portions described with reference to Fig. 1 or 2 will be omitted. In the optical transmitter according to this embodiment, a wavelength monitor PD 15 that monitors the intensity of a light which has passed through an etalon filter 14 is mounted on the Peltier element 1 in addition to the optical output monitor PD 3 of the LD 4. Voltages of the optical output monitor PD 3 and the wavelength monitor PD 15 are sent to voltage detectors 22 and 23, respectively, and a voltage ratio is calculated by a normalization voltage calculator 12. In the only optical output monitor PD 3, the wavelength shift of the LD 4 cannot be detected. However, when the transmission center wavelength of the etalon filter is set to be slightly shifted from the output wavelength of the optical transmitter, the shift of the wavelength can be detected as an increase/decrease of the normalization voltage. Accordingly, a value of an initial voltage ratio has been recorded in a reference voltage generator 24 in advance, and a switch 32 of an AFC (automatic frequency control) loop filter switching unit 300 is controlled by the voltage comparator 13 so as to coincide with the value of the initial voltage ratio. Then, one of an AFC heating loop filter 16 and an AFC cooling loop filter 17 is selected to control the temperature of the Peltier element 1. In the semiconductor laser, when the temperature of an active layer increases, the wavelength is shifted to a longer wavelength side. It can be judged whether cooling or heating should be conducted from the above result and the comparison result of the normalization voltage with a reference voltage in the voltage comparator 13.

As in the first embodiment, the reason why the loop filters should be switched over between heating and cooling will be described with reference to Figs. 6A and 6B. The control method according to this embodiment is based on the open-loop transfer characteristic of the temperature control circuit using the following Peltier element.

Figs. 6A and 6B show an example of the open-loop transfer characteristics of a route passing through the current controller 10, the Peltier element driver 11, the Peltier element 1, the LD 4, the etalon filter 14, the wavelength monitor PD 15, and the voltage detector 12 in the control circuit of the optical transmitter according to the second embodiment. In this example, Fig. 6A shows a frequency characteristic of a gain, Fig. 6B shows a frequency characteristic of a phase, with the heating time and the cooling time as parameters, respectively. The phase is delayed down to 360° in the vicinity of 4Hz at the cooling side. The transfer characteristic depends on what portion of the control circuit to be switched over. The phase characteristic is kept substantially constant at the heating side whereas the phase is changed only at the cooling side in any cases. This means that the transmission paths in the control system are different between heating and cooling as in the first embodiment. In addition, in a thermal response, the characteristic of a time constant of about 10 seconds which is determined by an overall laser diode module determines a response speed of the entire loop. This is irrelevant to the thermal response of the Peltier element, and in the transmission characteristic shown in Fig. 6, the similar transmission characteristic is exhibited in both of heating and cooling. The time constant 40 msec is the characteristic related to the thermal response of the Peltier element per se, and the transmission characteristics of heating and cooling are greatly different from each other in the vicinity of 4 Hz corresponding to the above time constant.

Since the transmission characteristics are different between heating and cooling as described above, according to this embodiment, the loop filters for heating and cooling are provided, and the respective optimum loop filters are selected and used on the basis of the heating and cooling information, thereby making it possible to realize an optical transmitter that realizes an optimum desired temperature arrival time without remarkably changing the size of the Peltier element, the drive current and the drive voltage, and stabilizes the oscillation wavelength having a sufficient phase margin.

The changeover of the loop filter is not only used by switching over two filters but also may be realized by switching over the parameters of one digital filter. Also, the thermistor is used as the temperature sensor in this embodiment, but the temperature sensor is not limited to the thermistor, which may be replaced by a thick film temperature sensor or a thin film temperature sensor. Also, the temperature sensor does not need to sense the temperature per se of an LD, the temperature sensor has only to measure the temperature in the vicinity of the LD. In addition, the LD may be formed of a modulator integrated LD that is integrated with a modulator.

The transmission center wavelength of the etalon filter may be made to coincide with the output wavelength of the optical transmitter. In this example, in the case where control is once made, for example, at the cooling side, and the wavelength shift becomes large, control is made at the heating side.

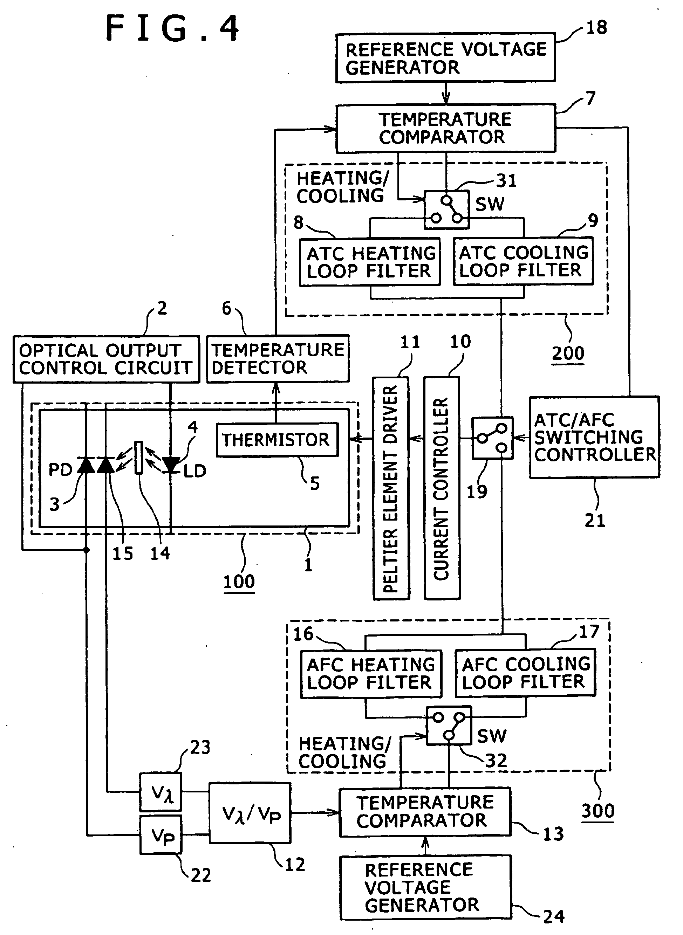

An optical transmitter according to another embodiment of the present invention will be described with reference to Fig. 4. In this example, Fig. 4 is a block diagram showing the laser diode of the optical transmitter and the temperature control circuit of the laser diode according to a third embodiment of the present invention.

The optical transmitter according to the third embodiment combines the structure of the optical transmitter that is excellent in the stability of the optical strength as described in the first embodiment with the structure of the optical transmitter which is excellent in the stability of the oscillation wavelength as described in the second embodiment. Accordingly, in the block diagram shown in Fig. 4, a detailed description of the portions described in Figs. 1 to 3 will be omitted. In the optical transmitter of this embodiment, the thermistor 5 for obtaining the temperature of the LD 4, the etalon filter 14 for obtaining the wavelength of the LD 4, and the wavelength monitor PD 15 are disposed in a laser module 100.

The output of the LD 4 is held constant by the optical output control circuit 2 that feeds back the voltage of the optical output monitor PD 3. Also, the output of the thermistor 5 passes through an optimum loop filter that is selected by an ATC loop filter switching unit 200, and is then fed back to the Peltier element 1 through the current controller 10 and the Peltier element driver 11. In addition, the wavelength shift of the LD 4 is detected by the voltage comparator 13, passes through an optimum loop filter which is selected by the AFC loop filter switching unit 300, and is then fed back to the Peltier element 1 through the current controller 10 and the Peltier element driver 11. In this example, a signal that is fed back to the Peltier element 1 is one of a signal from the ATC loop filter switching unit 200 and a signal from the ATC loop filter switching unit 300. The changeover of the signal is conducted by an ATC/AFC switching controller 24 and a switch 19. In this embodiment, the control of the ATC/AFC switching controller 24 and the switch 19 is conducted by the temperature comparator 7 of the ATC control. When the temperature falls within a predetermined range in the temperature comparator 7, the ATC/AFC switching controller 24 changes the switch 19 to the AFC control side.

According to this embodiment, the loop filters for heating and cooling are provided, and the respective optimum loop filters are selected and used on the basis of the heating and cooling information, thereby making it possible to realize an optical transmitter that realizes an optimum desired temperature arrival time without remarkably changing the size of the Peltier element, the drive current and the drive voltage, and stabilizes the optical output and the oscillation wavelength under the control having a sufficient phase margin.

The changeover of the respective loop filters is not only used by switching over two filters but also may be realized by switching over the parameter s(constants) of one digital filter. In this case, the parameters are rewritten by software that has been programmed in a controller not shown. In addition, not only the four filters are switched over and used but also the changeover of the respective loop filter may be realized by switching over the parameter of one digital filter.

Also, in this embodiment, the ATC/AFC switching controller 24 is controlled by the temperature comparator 7 of the ATC control, but the present invention is not limited to this structure. That is, the ATC/AFC switching controller 24 may be controlled by the voltage comparator 13 of the AFC control, or may be controlled by both of the temperature comparator 7 of the ATC control and the voltage comparator 13 of the AFC control. Also, the ATC/AFC switching controller 24 may be controlled by a higher controller not shown.

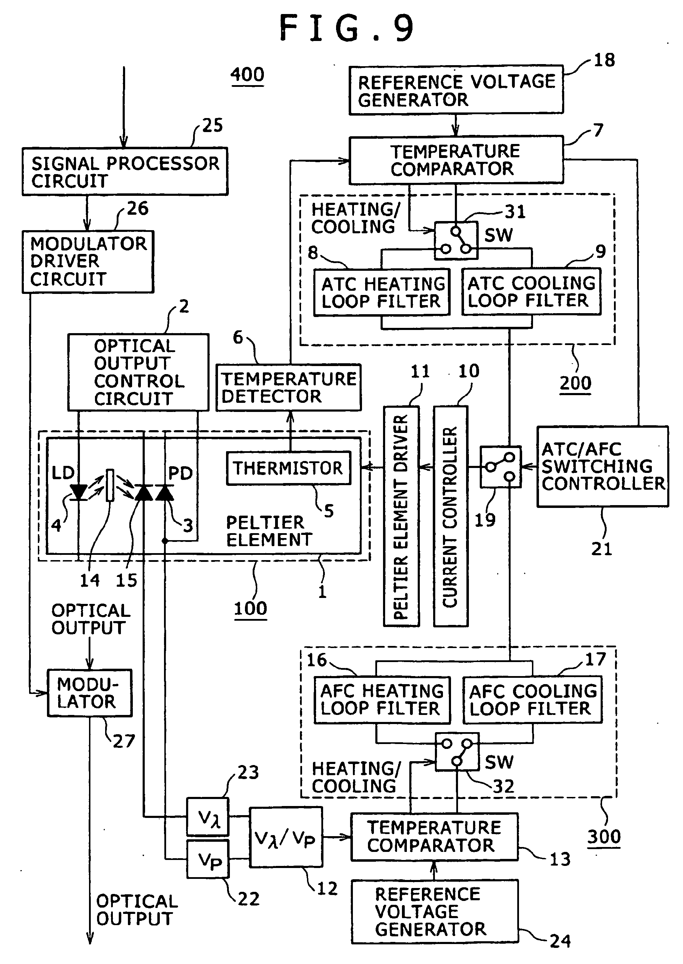

An optical transmitter according to another embodiment of the present invention will be described with reference to Fig. 9. In this example, Fig. 9 is a block diagram showing an optical transmitter according to a fourth embodiment of the present invention. The optical transmitter of this embodiment adds another circuit block of the optical transmitter to the block diagram of the laser diode and the temperature control circuit of the laser diode in the third embodiment. Therefore, a detailed description of the portions described with reference to Figs. 1 to 4 will be omitted. An optical transmitter 400 of Fig. 9 includes a signal processing circuit 25 that multiplexes 16 input signals of 622 Mbit/s, a modulator driving circuit that converts the signals of 10 Gbit/s that have been multiplexed by the signal processing circuit 25 into a drive signal of an external modulator 27, a laser diode module 100, a temperature control circuit of the laser diode module 100, and optical components such as a lens which is not shown.

Since the optical transmitter of this embodiment has the loop filters for heating and cooling, the respective optimum loop filters can be selected and used on the basis of the heating and cooling information. As a result, the optical transmitter can realize an optimum desired temperature arrival time with suppressing an increase in the size of the Peltier element, an increase in the drive current and an increase in the drive voltage, and stabilizes the optical output and the oscillation wavelength under the control having a sufficient phase margin.

As is apparent from the first embodiment and the second embodiment, it is not necessary to provide both of the ATC temperature control circuit and the AFC temperature control circuit, and one of those temperature control circuits may be used according to the intended use. Also, the modulator is disposed outside of the LD in this embodiment. The same effect is obtained by a modulator integrated laser diode in which the LD and the modulator are integrated together.

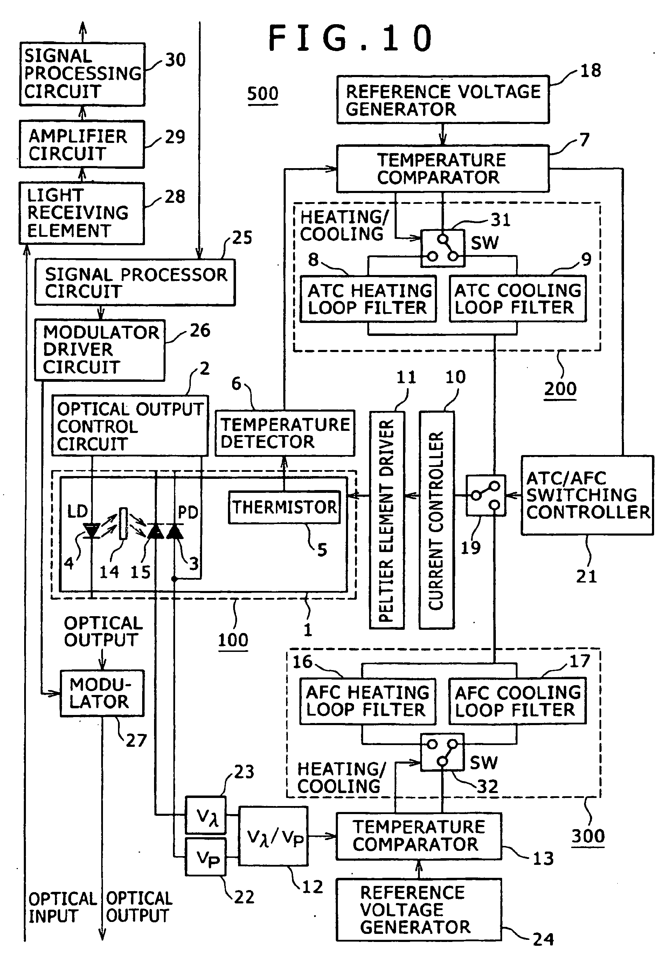

An optical transmitter/receiver according to another embodiment of the present invention will be described with reference to Fig. 10. In this example, Fig. 10 is a block diagram showing an optical transceiver according to a fifth embodiment of the present invention. The optical transceiver of this embodiment adds another circuit block of the optical receiver to the block diagram of the optical transmitter of the fourth embodiment. Therefore, a detailed description of the portions described with reference to Figs. 1 to 4 and 9 will be omitted. An optical transmitter/receiver 500 of Fig. 10 includes a signal processing circuit 25 that multiplexes 16 input signals of 622 Mbits/s, a modulator driving circuit that converts the signal of 10 Gbits/s that have been multiplexed by the signal processing circuit 25 into a drive signal of an external modulator 27, a laser diode module 100, a temperature control circuit of the laser diode module 100, a light receiving element 28 that converts the optical signal of 10 Gbits/s which has been transmitted from the transmission path into an electric signal, an amplifying circuit 29 that amplifies the converted electric signal, a signal processing circuit 30 that divides the amplified signal into 16 signals of 622 Mbits/s, and optical components such as a lens which is not shown.

Since the optical transmitter/receiver of this embodiment has the loop filters for heating and cooling, the respective optimum loop filters can be selected and used on the basis of the heating and cooling information. As a result, the optical transmitter/receiver can realize an optimum desired temperature arrival time with suppressing an increase in the size of the Peltier element, an increase in the drive current and an increase in the drive voltage, and stabilizes the optical output and the oscillation wavelength under the control having a sufficient phase margin.

As is apparent from the first embodiment and the second embodiment, it is not necessary to provide both of the ATC temperature control circuit and the AFC temperature control circuit, and one of those temperature control circuits may be used according to the intended use. Also, the modulator is disposed outside of the LD in this embodiment. The same effect is obtained by a modulator integrated laser diode in which the LD and the modulator are integrated together.

According to the present invention, there can be provided an optical transmitter and a method for transmitting an optical signal, which can set the temperature of the laser diode to a desired temperature in a short period of time under various environmental temperature circumstances.

## Claims

1. An optical transmitter, comprising:
a laser diode (4) that is mounted on a Peltier element;
a temperature sensor (5; 3, 15) of the laser diode;, and
a feedback loop (20, 200, 300) that drives the Peltier element on the basis of a temperature that is detected by the temperature sensor,
**characterised in that** said feedback loop includes a first loop filter (9;17) and a second loop filter (8; 16) and is adapted to use
said first loop filter to drive the Peltier element so as to cool the laser diode, and to use said second loop filter to drive the Peltier element so as to heat the laser diode.

2. An optical transmitter, comprising:
a laser diode (4) that is mounted on a Peltier element (1);
a first photodiode (3) that monitors an output of the laser diode;
a second photodiode (15) that monitors a wavelength shift of the laser diode; and
a feedback loop (20, 200, 300) that drives the Peltier element on the basis of a first voltage and a second voltage which are detected
from the first photodiode and the second photodiode,
**characterised in that** said feedback loop includes a first loop filter (17) and a second loop filter (16) and is adapted to use
said first loop filter to drive the Peltier element so as to cool the laser diode, and to use the second loop filter to drive the Peltier element so as to heat the laser diode.

3. A method for transmitting an optical signal by modulating output light from a laser diode (4) mounted on a Peltier element (1), the method comprising the steps of:
measuring a temperature of the laser diode;
judging whether a mount surface of the Peltier element on which the laser diode is mounted should be heated or cooled, on the basis of the measured temperature;
selecting a first loop filter (8; 16) in a feedback loop for driving the Peltier element, when it is judged that heating should be made; and
selecting a second loop filter (9;17) in the feedback loop when it is judged that cooling should be made.

4. A method for transmitting an optical signal by modulating output light from a laser diode (4) mounted on a Peltier element (1), the method comprising the steps of:
monitoring an optical output of the laser diode;
monitoring an optical output wavelength of the laser diode;
calculating a ratio between the optical output and the optical output wavelength;
judging whether a mount surface of the Peltier element on which the laser diode is mounted should be heated or cooled, on the basis of said ratio;
selecting a first loop filter (8; 16) in a feedback loop for driving the Peltier element, when it is judged that heating should be made; and
selecting a second loop filter (9; 17) in feedback loop, when it is judged that cooling should be made.

## Patentansprüche

1. Optischer Sender, aufweisend:
eine auf einem Peltier-Element befestigte Laserdiode (4),
einen Temperatursensor (5; 3, 15) für die Laserdiode, und
eine Rückkopplungsschleife (20, 200, 300), die das Peltier-Element aufgrund einer vom Temperatursensor erfaßten Temperatur ansteuert,
**dadurch gekennzeichnet, daß**
die Rückkopplungsschleife ein erstes (9; 17) und ein zweites Schleifenfilter (8; 16) enthält und eingerichtet ist, das erste Schleifenfilter zum Ansteuern des Peltier-Elements, um die Laserdiode zu kühlen, und das zweite Schleifenfilter zum Ansteuern des Peltier-Elements, um die Laserdiode zu heizen, zu verwenden.

2. Optischer Sender, aufweisend:
eine auf einem Peltier-Element (1) befestigte Laserdiode (4),
eine erste Photodiode (3) zum Überwachen der Ausgabe der Laserdiode,
eine zweite Photodiode (15) zum Überwachen einer Wellenlängenverschiebung der Laserdiode und
eine Rückkopplungsschleife (20, 200, 300), die das Peltier-Element aufgrund einer ersten und einer zweiten Spannung ansteuert, die von der ersten und der zweiten Photodiode ausgehend erfaßt werden,
**dadurch gekennzeichnet, daß**
die Rückkopplungsschleife ein erstes (17) und ein zweites Schleifenfilter (16) enthält und eingerichtet ist, das erste Schleifenfilter zum Ansteuern des Peltier-Elements, um die Laserdiode zu kühlen, und das zweite Schleifenfilter zum Ansteuern des Peltier-Elements, um die Laserdiode zu heizen, zu verwenden.

3. Verfahren zum Senden eines optischen Signals durch Modulieren einer Lichtausgabe einer auf einem Peltier-Element (1) befestigten Laserdiode (4), mit folgenden Schritten:
Messen einer Temperatur der Laserdiode,
Beurteilen aufgrund der gemessenen Temperatur, ob eine Befestigungsfläche des Peltier-Elements, auf der die Laserdiode befestigt ist, geheizt oder gekühlt werden soll,
Wählen eines ersten Schleifenfilters (8; 16) in einer Rückkopplungsschleife zum Ansteuern des Peltier-Elements, wenn beurteilt wird, daß geheizt werden soll, und
Wählen eines zweiten Schleifenfilters (9; 17) in der Rückkopplungsschleife, wenn beurteilt wird, daß gekühlt werden soll.

4. Verfahren zum Senden eines optischen Signals durch Modulieren einer Lichtausgabe einer auf einem Peltier-Element (1) befestigten Laserdiode (4), mit folgenden Schritten:
Überwachen einer optischen Ausgabe der Laserdiode,
Überwachen einer optischen Ausgabewellenlänge der Laserdiode,
Berechnen eines Verhältnisses zwischen der optischen Ausgabe und der optischen Ausgabewellenlänge,
Beurteilen aufgrund des genannten Verhältnisses, ob eine Befestigungsfläche des Peltier-Elements, auf der die Laserdiode befestigt ist, geheizt oder gekühlt werden soll,
Wählen eines ersten Schleifenfilters (8; 16) in einer Rückkopplungsschleife zum Ansteuern des Peltier-Elements, wenn beurteilt wird, daß geheizt werden soll, und
Wählen eines zweiten Schleifenfilters (9; 17) in der Rückkopplungsschleife, wenn beurteilt wird, daß gekühlt werden soll.

## Revendications

1. Emetteur optique, comportant :
une diode laser (4) qui est montée sur un élément Peltier,
un capteur de température (5 ; 3, 15) de la diode laser, et
une boucle d'asservissement (20, 200, 300) qui commande l'élément Peltier sur la base d'une température qui est détectée par le capteur de température,
**caractérisé en ce que** ladite boucle d'asservissement inclut un premier filtre de boucle (9 ; 17) et un second filtre de boucle (8 ; 16) et est adaptée pour utiliser ledit premier filtre de boucle pour commander l'élément Peltier de manière à refroidir la diode laser, et pour utiliser ledit second filtre de boucle pour commander l'élément Peltier de manière à chauffer la diode laser.

2. Emetteur optique, comportant :
une diode laser (4) qui est montée sur un élément Peltier (1),
une première photodiode (3) qui surveille une sortie de la diode laser,
une seconde photodiode (15) qui surveille un changement de longueur d'onde de la diode laser, et
une boucle d'asservissement (20, 200, 300) qui commande l'élément Peltier sur la base d'une première tension et d'une seconde tension qui sont détectées à partir de la première photodiode et de la seconde photodiode,
**caractérisé en ce que** ladite boucle d'asservissement inclut un premier filtre de boucle (17) et un second filtre de boucle (16) et est adaptée pour utiliser ledit premier filtre de boucle pour commander l'élément Peltier de manière à refroidir la diode laser, et pour utiliser le second filtre de boucle pour commander l'élément Peltier de manière à chauffer la diode laser.

3. Procédé pour transmettre un signal optique en modulant de la lumière de sortie provenant d'une diode laser (4) montée sur un élément Peltier (1), le procédé comportant les étapes consistant à :
mesurer une température de la diode laser,
juger si une surface de montage de l'élément Peltier sur lequel la diode laser est montée doit être chauffée ou refroidie, sur la base de la température mesurée,
sélectionner un premier filtre de boucle (8 ; 16) dans une boucle d'asservissement pour commander l'élément Peltier lorsque l'on juge qu'un chauffage doit être réalisé, et
sélectionner un second filtre de boucle (9 ; 17) dans la boucle d'asservissement lorsque l'on juge qu'un refroidissement doit être réalisé.

4. Procédé pour transmettre un signal optique en modulant de la lumière de sortie provenant d'une diode laser (4) montée sur un élément Peltier (1), le procédé comportant les étapes consistant à :
surveiller une sortie optique de la diode laser,
surveiller une longueur d'onde de sortie optique de la diode laser,
calculer un rapport entre la sortie optique et la longueur d'onde de sortie optique,
juger si une surface de montage de l'élément Peltier sur lequel la diode laser est montée doit être chauffée ou refroidie, sur la base dudit rapport,
sélectionner un premier filtre de boucle (8 ; 16) dans une boucle d'asservissement pour commander l'élément Peltier lorsque l'on juge qu'un chauffage doit être réalisé, et
sélectionner un second filtre de boucle (9 ; 17) dans la boucle d'asservissement lorsque l'on juge qu'un refroidissement doit être réalisé.
